# EUROPEAN PATENT SPECIFICATION

(11) **EP 3 491 674 B1**
(45) Date of publication and mention of the grant of the patent: **12.01.2022**
(21) Application number: 17835403.1
(22) Date of filing: 31.07.2017
(51) Int. Cl.: H01L 31/05, H01L 31/0224, H01L 31/18, H01L 31/02, H01L 31/042, H02S 20/25, H01L 31/043

(54) **SHINGLED SOLAR CELLS OVERLAPPING ALONG NON-LINEAR EDGES**
SCHINDELFÖRMIGE, ENTLANG NICHTLINEARER KANTEN ÜBERLAPPENDE SOLARZELLEN
CELLULES SOLAIRES IMBRIQUÉES SE CHEVAUCHANT LE LONG DE BORDS NON LINÉAIRES

(30) Priority: 29.07.2016 US 201662368916 P; 30.12.2016 US 201615395727; 19.05.2017 US 201762508787 P
(43) Date of publication of application: 05.06.2019
(73) Proprietor: Maxeon Solar Pte. Ltd., Singapore 018981 (SG)
(72) Inventor: CASWELL, Nathaniel, San Jose CA 95134 (US); RUIZ, Maritza, San Jose CA 95134 (US); LANCE, Tamir, San Jose CA 95134 (US); BECKETT, Nathan, San Jose CA 95134 (US); ALMOGY, Gilad, San Jose CA 95134 (US); DEGRAAFF, David, San Jose CA 95134 (US)
(74) Representative: Savoca, Agatino
(86) International application number: PCT/US2017/044588
(87) International publication number: WO 2018/023103

(56) References cited:
- KR-A- 20090 084 741
- US-A- 3 369 939
- US-A1- 2003 127 128
- US-A1- 2012 090 673
- US-A1- 2012 234 375
- US-A1- 2014 124 014
- US-A1- 2014 144 479
- US-A1- 2015 129 019
- US-A1- 2015 349 153

## Description

### TECHNICAL FIELD

The subject matter described in this specification relates generally to photovoltaic solar cells and in particular to shingled solar cells.

### BACKGROUND

Photovoltaic (PV) cells, commonly known as solar cells, are well- known devices for converting solar radiation into electrical energy. PV cells can be assembled into PV modules (also referred to as solar modules), which may be used to convert sunlight into electricity. A solar energy system typically includes multiple PV modules, one or more inverters, and interconnection wiring. The PV module can include a frame, which can be mounted on top of a building, and the other components can be located on the outside or inside of the building to interface with an electric system. US 2014/0144479 A1 relates to a photo electric conversion module. US 3 369 939 A relates to a photovoltaic generator. US 2003/127128 A1 refers to light-weight thin-film photovoltaic cells and a method of bonding them one to another.

### SUMMARY

The present invention defines a solar device according to claim 1.

The present invention also defines a method according to claim 12.

Further, advantageous embodiments are defined in dependent claims.

### BRIEF DESCRIPTION OF THE DRAWINGS

The drawings, described below, are for illustrative purposes and are not necessarily drawn to scale. The drawings are not intended to limit the scope of this disclosure in any way.
Figures 1A-B illustrate an example solar device of solar cells arranged in a shingled manner with the ends of adjacent solar cells overlapping along nonlinear edges according to the invention;
Figure 1C is a side view of an example encapsulated solar device;
Figure 1D shows an example solar array coupled to an electrical system;
Figures 2A-B illustrate an example photovoltaic wafer not being part of the invention that can be divided into solar cells that are arranged in a shingled manner with the ends of adjacent solar cells overlapping along non-linear edges;
Figure 2C shows a closer, cut-away view of an non-linear scribe line;
Figure 2D illustrates two example non-sinusoidal patterns;
Figures 3A-G illustrate an example process for producing a solar device of solar cells arranged in a shingled manner with the ends of adjacent solar cells overlapping along non-linear edges, not being part of the invention;
Figures 4A-G illustrate another example process for producing a solar device of solar cells arranged in a shingled manner with the ends of adjacent solar cells overlapping along non-linear edges, not being part of the invention;
Figure 5 is a flow diagram of an example method for producing a solar device of solar cells arranged in a shingled manner with the ends of adjacent solar cells overlapping along non-linear edges, not being part of the invention;
Figure 6 illustrates an example solar device of solar cells arranged in a shingled manner with a sacrificial solar cell, not being part of the invention;
Figures 7A-C illustrate a conductive busbar that can be used in shingled solar cell devices, not being part of the invention;
Figures 8A-B illustrate shingled solar device 800 according to the invention having conductive busbars that vary in width;
Figure 9 shows a solar device 900 not being part of the invention;
Figure 10 shows a photovoltaic wafer 1000 not being part of the invention;
Figure 11 shows another photovoltaic wafer 1100 not being part of the invention;
Figure 12 shows an example for arranging solar cells not being part of the invention; and
Figure 13 shows an example for arranging solar cells not being part of the invention;

### DETAILED DESCRIPTION of EMBODIMENTS

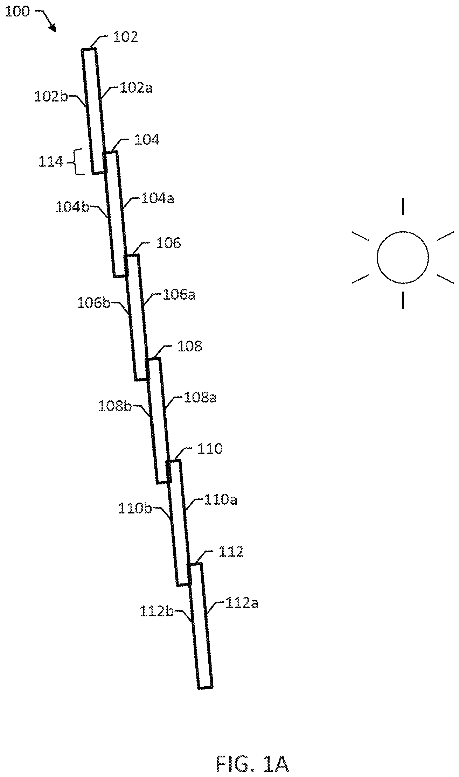

Figures 1A-B illustrate an example solar device 100 of solar cells arranged in a shingled manner with the ends of adjacent solar cells overlapping along non-linear edges in accordance with the invention.

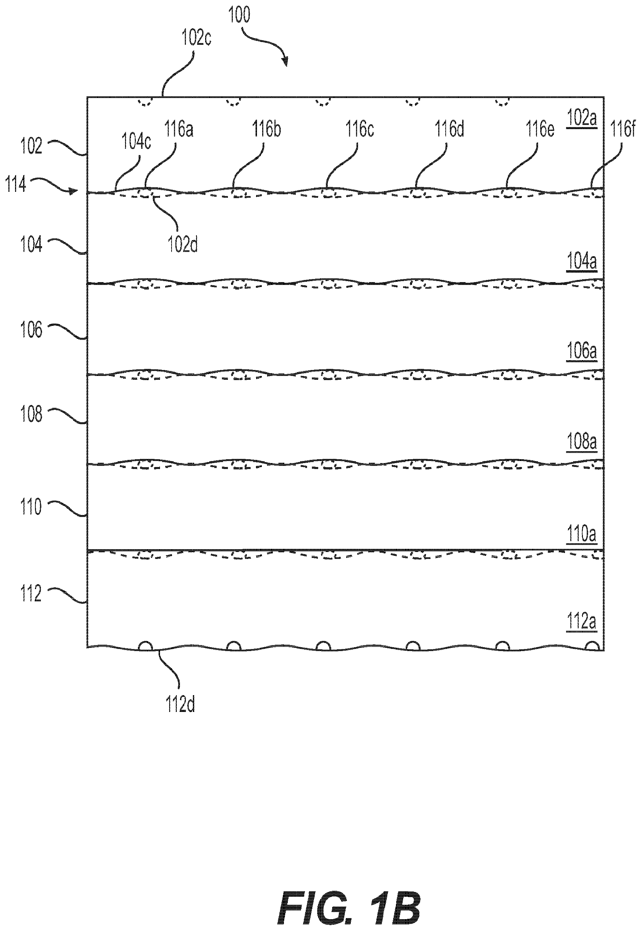

Figure 1A shows a side view of the solar device 100 that illustrates the orientation of the solar device 100 towards the sun (or other light source such as mirrors facing the sun), and Figure 1B shows a back view of the solar device 100 that illustrates the non-linear edges. The solar device 100 may be referred to as a "supercell" or a "hypercell" or a "solar cell strip."

Referring to Figure 1A, the solar device 100 includes solar cells 102, 104, 106, 108, 110, and 112 arranged in a shingled manner with the ends or long edges of adjacent solar cells overlapping and electrically connected to form, e.g., a series-connected string. Each solar cell 102, 104, 106, 108, 110, and 112 has two relatively long edges and two relatively short edges. One or both of the long edges are non-linear and have a non-linear shape, as in one or both of the long edges, which extend between the short edges, is/are not arranged in a straight line between respective ends of the short edges. Each solar cell 102, 104, 106, 108, 110, and 112 can include a semiconductor diode structure and electrical contacts to the semiconductor diode structure. The solar cells are configured, by virtue of the semiconductor diode structures, so that electric current is generated in the solar cells when light shines on front surfaces 102a, 104a, 106a, 108a, 110a, and 112a of the solar cells. The electric current can then be provided to an external load.

For example, each solar cell 102, 104, 106, 108, 110, and 112 can be a crystalline silicon solar cell having a front (lighted side) surface 102a, 104a, 106a, 108a, 110a, and 112a and a rear (shaded side) surface 102b, 104b, 106b, 108b, 110b, and 112b. The front and rear surfaces can include surface metallization structures providing electrical contact to opposite sides of an n-p junction.

Any appropriate type of solar cells can be used in the solar device 100. For example, the front surface metallization structure can be disposed on a semiconductor layer of n-type conductivity, and the rear surface metallization structure can be disposed on a semiconductor layer of p-type conductivity. In another example, the front surface metallization structure can be disposed on a semiconductor layer of p-type conductivity, and the rear surface metallization structure can be disposed on a semiconductor layer of n-type conductivity.

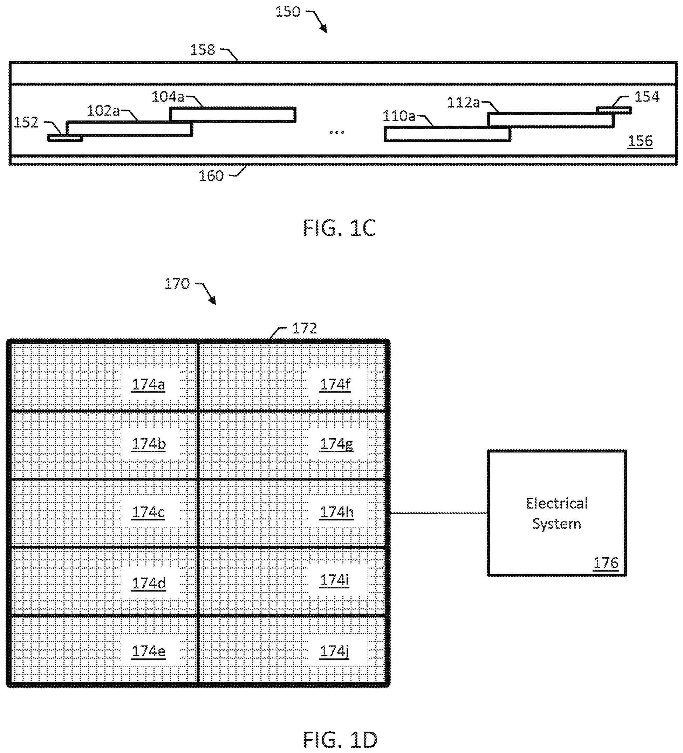

In the solar device 100 of Figure 1, adjacent solar cells are conductively bonded to each other in the region in which they overlap by an electrically conducting bonding material that electrically connects the front surface metallization structure of one solar cell to the rear surface metallization structure of the adjacent solar cell. For example, consider the first and second solar cells 102 and 104 in the solar device 100. The second solar cell 104 is adjacent to the first solar cell 102 and overlaps the first solar cell 102 in a region 114 where the first and second solar cells 102 and 104 are electrically connected.

Appropriate electrically conducting bonding materials may include, for example, electrically conducting adhesives and electrically conducting adhesive films and adhesive tapes, and conventional solders. In some examples, the electrically conducting bonding material provides mechanical compliance in the bond between the adjacent solar cells that accommodates stress arising from mismatch between the coefficient of thermal expansion (CTE) of the electrically conducting bonding material and that of the solar cells (e.g., the CTE of silicon).

Referring to Figure 1B, which is a back view of the solar device 100, the solar cells 102, 104, 106, 108, 110, and 112 have been shaped and shingled so that, where adjacent solar cells overlap, the solar cells overlap along non-linear edges, which are the long edges of the solar cells that extend in generally parallel directions. For purposes of illustration, Figure 1B shows edges of the solar cells that face the viewer as dark lines, and Figure 1B shows edges of solar cells that are hidden behind other solar cells in overlapping regions as light lines, as if the solar cells were transparent in those regions (i.e., Figure 1B is an "x-ray" view). In this view, the viewer can see contact pads as circular shapes in the regions where adjacent solar cells overlap.

For example, consider the region 114 where the first and second solar cells 102 and 104 overlap. The top edge 104c of the second solar cell 104 extends between a first direction towards a top edge 102c of the solar device 100 and a second direction, opposite the first direction, towards a bottom edge 112d of the solar device 100. The bottom edge 102d of the first solar cell 102 extends between the same two directions but mirrors, in the same two directions, the top edge 104c of the second solar cell 104.

Because the bottom edge 102d mirrors the top edge 104c, the bottom edge 102d extends towards the first direction where the top edge 104c extends towards the second direction, and the bottom edge 102d extends towards the second direction where the top edge 104c extends towards the first direction. As a consequence of the non-linear edges, the bottom edge 102d of solar cell 102 and the top edge 104c of solar cell 104 have the largest overlapping area over the contact pads 116a-f and the smallest overlapping area at mid-points between those contact pads.

The non-linear edges have protruding portions, which are portions of the solar cell that protrude or extend away from a center of the solar cell, and recessing portions, which are portions of the solar cell that recess towards the center of the solar cell. The contact pads are located in the protruding portions of the solar cell and the protruding portions of one solar cell match with protruding portions of an adjacent solar cell. As such, contact pads provided in the protruding portions of the solar cells match or line up (e.g., in a row) and can be electrically connected with a conductive adhesive bonding material. The contacts pads can be discrete contact pads, i.e., such that each contact pad is a discrete electrical contact point between adjacent solar cells.

Using solar cells that overlap along non-linear edges can reduce, compared to using linear or straight edges, the amount of material needed to produce a solar device at a given power rating. In modules with straight edges, potential active area can be shaded due to overlap. For example, the entire area between discrete connection pads may be shaded by a top solar cell, just to accommodate space for the discrete connection pads.

To illustrate the potential for saving material, consider the following example. Suppose that each of the solar cells 102, 104, 106, 108, 110, and 112 has a length of about 156 mm and an average a width of about 26 mm. Also suppose that an overlap of 1.6 mm is required at the contact pads. Under these conditions, a 0.8 mm sinusoid pattern at the edges can reduce, compared to straight edges, average cell-to-cell overlap by up to half (0.8 mm) while still having the same overlap at the contact pads (1.6 mm).

Furthermore, consider a solar string having 83 solar cells with straight edges. By using solar cells that overlap along non-linear edges and reducing the average overlap from 1.6 mm to 0.8 mm, the material used can be reduced by up to 2.5 solar cells per string. In some examples, an equivalent solar string can use 81 solar cells instead of 83, without a reduction in string power.

The solar cells can be sized to any appropriate dimensions. In some examples, the solar cells each have a length of about 156 mm and an average width of about 26 mm, so that six solar cells can be prepared on a standard 156 mm × 156 mm silicon wafer. In another example, eight solar cells having dimensions of about 19.5 mm ×.156 mm can be prepared from a standard silicon wafer. More generally, the solar cells can have aspect ratios of, for example, about 1:2 to about 1:20 and may be prepared from standard size wafers or from wafers of any other appropriate dimensions.

Figure 1C is a side view of an example solar device that has been encapsulated into a solar module 150. The solar module 150 includes the solar cells 102, 104, 106, 108, 110, and 112 arranged in a shingled manner. The solar module 150 also includes conductive interconnects 152 and 154 at the ends of the solar cells that can be configured to connect the solar cells, e.g., to other solar cells or to an external load. Any appropriate electrical configuration can be used, e.g., combinations of serial and parallel connections.

The solar module 150 includes an encapsulant 156 encapsulating the solar cells. The encapsulant 156 can be a polymer, for example, a thermoplastic olefin polymer. The solar module 150 also includes a transparent front sheet 158 and a back sheet 160. The front sheet 158 can be, e.g., made of glass. The back sheet 160 can also be made of glass or made of a polymer. A solar module 150 including a glass front sheet 158 and a glass back sheet 160 may also be referred to as a glass-glass module or a bifacial module.

Figure 1D shows an example solar array 170 coupled to an electrical system 176. The solar array 170 is configured to provide power to the electrical system 176. The solar array 170 includes a frame 172 and a number of solar modules 174a-j mounted on the frame 172. Each of the solar modules 174a-j can be configured as the solar module 150 of Figure 1C, for example. The solar modules 174a-j are electrically connected as a combination of serial and/or parallel electrical connections, depending on the system design, to provide a common output to the electrical system 176.

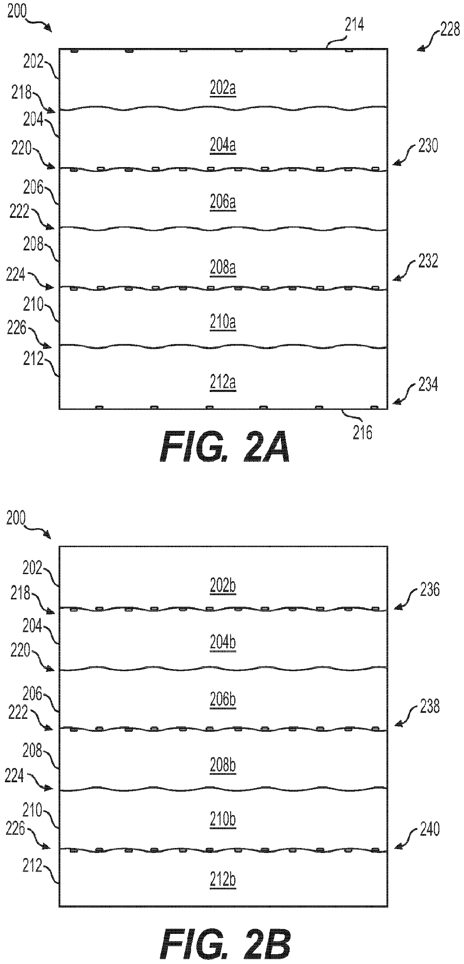

Figures 2A-B illustrate an example photovoltaic wafer 200 not being part of the invention that can be divided into solar cells shaped for arrangement in a shingled manner with the ends of adjacent solar cells overlapping along non-linear edges. The wafer 200 includes six regions 202, 204, 206, 208, 210, and 212 that will be solar cells when the wafer 200 is divided along five non-linear scribe lines 218, 220, 222, 224, and 226. The wafer 200 also includes a straight top edge 214 and a straight bottom edge 216.

Six regions are shown for purposes of illustration; in general, any appropriate number of regions can be used. Typically, the regions 202, 204, 206, 208, 210, and 212 each have a long edge and a short edge and are arranged to overlap at the long edges; however, the regions can have any appropriate dimensions. Scribe lines are shown for purposes of illustration even though they may not be necessary in some examples depending on the method used to divide the wafer 200.

Figure 2A is a front view of the wafer 200 that shows front surfaces 202a, 204a, 206a, 208a, 210a, and 212a of the regions 202, 204, 206, 208, 210, and 212. Four rows of contact pads 228, 230, 232, and 234 are disposed on the front of the wafer 200. The top row 228 is a straight row that follows the straight top edge 214, and the bottom row 234 is a straight row that follows the straight bottom edge 216.

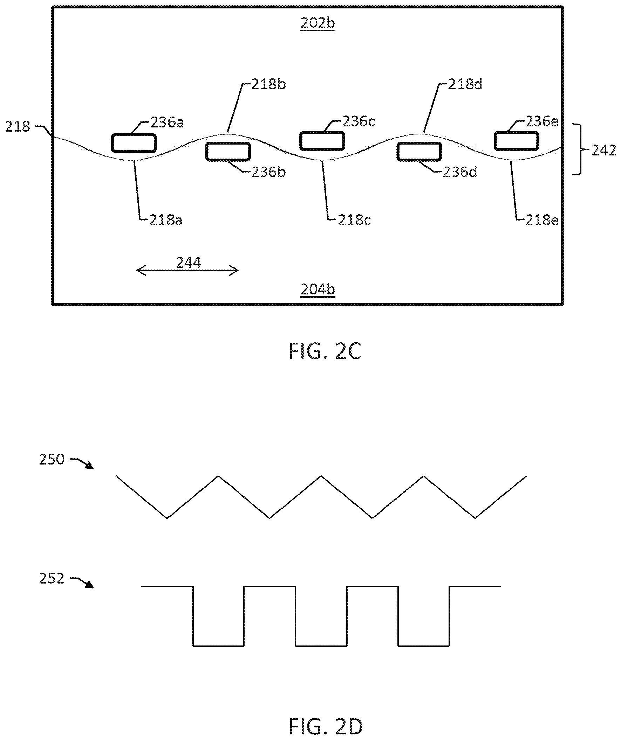

The interior rows 230 and 232 follow two of the interior non-linear scribe lines 220 and 224, e.g., as described further below with reference to Figure 2C. So, on the front of the wafer 200, the rows of contact pads 228, 230, 232, and 234 are disposed in an alternating fashion along the along the non-linear scribe lines 218, 220, 222, 224, and 226, i.e., every other scribe line has a row of contact pads disposed along the scribe line.

Figure 2B is a back view of the example wafer 200 that shows back surfaces 202b, 204b, 206b, 208b, 210b, and 212b of the regions 202, 204, 206, 208, 210, and 212. Three rows of contact pads 236, 238, and 240 are disposed on the back of the wafer 200. The rows 236, 238, and 240 follow the three interior non-linear scribe lines 218, 222, and 226 that do not have contact pads on the front of the wafer 200. So, on the back of the wafer 200, the rows of contact pads 236, 238, and 240 are disposed in an alternating fashion along the along the non-linear scribe lines 218, 222, and 226, i.e., every other scribe line has a row of contact pads disposed along the scribe line.

Figure 2C shows a closer, cut-away view of the scribe line 218 separating the top region 202 from the adjacent region 204 below the top region 204 on the back of the wafer 200. The scribe line 218 is a sinusoid that extends between a direction towards the top region 202 and a direction towards the adjacent region 204 below the top region 202. Where the scribe line 218 reaches troughs 218a, 218c, and 218e, contact pads 236a, 236c, and 236e are disposed above the troughs 218a, 218c, and 218e on the back surface 202b of the top region 202. Where the scribe line 218 reaches peaks 218b and 218d, contact pads 236b and 236d are disposed below the peaks 218b and 218d on the back surface 204b of the adjacent region 204 below the top region 202.

In general, the contact pads 236a-e are disposed laterally along the scribe line 218 at equal distances, where the distances are equal to the lateral peak-to-trough distance 244 (e.g., 3 mm to 30 mm) of the scribe line 218. The contact pads 236a-e alternate between two vertical positions. The vertical positions depend on the vertical peak-to-trough distance 242 of the scribe line 218 and the dimensions of the contact pads 236a-e.

In some examples, the contact pads 236a-e are square or have a rectangular shape elongated parallel or substantially parallel (i.e., within 5 or 10 degrees) to the top and bottom edges 214 and 216 of the wafer. The contact pads 236a-e may have widths perpendicular to the long side of the wafer 200 of about 1 mm to about 5 mm, for example, and lengths parallel to the long side of the wafer 200 of about 1 mm to about 10 mm for example. The contact pads 236a-e may each have a surrounding barrier acting as a dam to form a moat between the contact pad and the barrier. Portions of uncured conductive adhesive bonding material that flow off of the contact pads 236a-e, or that miss the contact pads when dispensed, may be confined to the moats.

In an example, each of the scribe lines 218, 220, 222, 224, and 226 follows a sinusoidal pattern having a number of periods based on a designed number of contact pads in a row and a vertical peak-to-trough distance based on the size of the contact pads. The shape of the scribe lines 218, 220, 222, 224, and 226 is also configured so that the wafer 200 can be cleaved along the scribe lines, e.g., so that the wafer 200 cleaves cleanly with a particular yield loss in a particular manufacturing setting. The sinusoids are mirrored, i.e., offset in phase in an alternating fashion, so that each scribe line is rising while its neighboring scribe lines are falling.

In some examples, the scribe lines 218, 220, 222, 224, and 226 follow a non-sinusoidal pattern that extends between a first direction towards the top edge 214 of the wafer 200 and a second direction towards the bottom edge 216 of the wafer 200. The pattern is a repeating pattern that has a defined number of periods and peak-to-trough amplitude. Figure 2D illustrates two example non-sinusoidal patterns 250 and 252. The first pattern 250 is a triangle wave. The second pattern 252 is a square wave. The square wave may not be useful in manufacturing settings where the wafer 200 is scribed and cleaved since it may not cleave acceptably, but the square wave pattern can be used in some other examples, e.g., where the wafer 200 is sawed.

In some aspects, one or more of the scribe lines 218, 220, 224, and 226 are non-linear. That is, the wafer 200 can be scribed with non-linear or non-straight scribe lines to result in non-linear or non-straight edged solar cell strips. In an example, outer solar cell strips can have linear or straight edges that are not scribed or cleaved, whereas inner solar cell strips can have non-linear or non-straight scribed or cleaved edges. These non-linear edges can have a non-linear shape that is not straight. In an example, the non-linear edges are undulated or have undulated portions. In an example, the non-linear shape can have a periodic waveform shape. This periodic waveform shape can be sinusoidal, square, rectangular, triangular, sawtooth, or a combination thereof where the undulated portions take the shape of one or more of the peaks and valleys of a sinusoidal, square, rectangular, triangular, or sawtooth pattern. The non-linear shape can also have a non-periodic waveform shape. The non-linear shape can be a combination of periodic waveform shapes. The non-linear shape can be symmetrical or non-symmetrical with respect to any axis thereof. Further, the non-linear shape can have linear portions that are straight and are interrupted by undulated portions or a protruding portion. The protruding portion can have a smooth or jagged shape that is not wavy. In an example, one or more of the scribe lines 218, 220, 224, and 226 can be non-linear and include portions that are non-linear and linear.

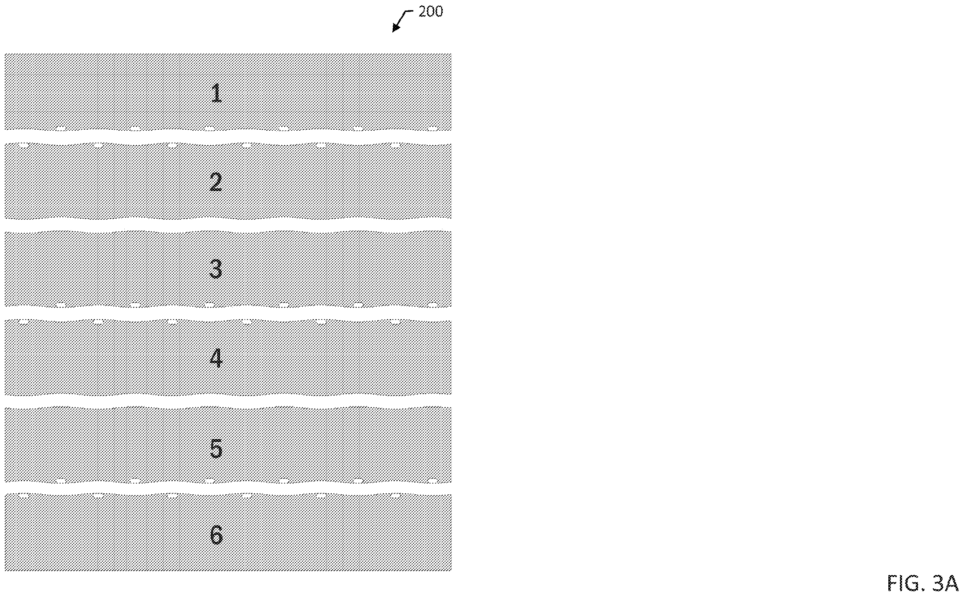

Figures 3A-G illustrate an example process for producing a solar device from the wafer 200 of Figures 2A-B, not being part of the invention. The process can be performed, e.g., by a manufacturing system including a shingling robot. The wafer 200 is scribed, pasted (such as paste printed), and cleaved along the non-linear scribe lines. Then the robot arranges the remaining solar cell strips in a shingled manner with the ends of adjacent strips overlapping along the non-linear edges. The robot rotates every other strip by 180 degrees.

For purposes of illustration, each of the strips is labelled with a number from one to six. As shown in Figures 3A-G, the numbers rotate with the strips (i.e., the numbers maintain their orientation with respect to the strips) to illustrate the robot rotating every other strip by 180 degrees. The strips that remain after cleaving are shown on the left side, and the strips that have been picked, rotated (if appropriate in view of rotating every other strip), and shingled into the solar device are shown on the right side.

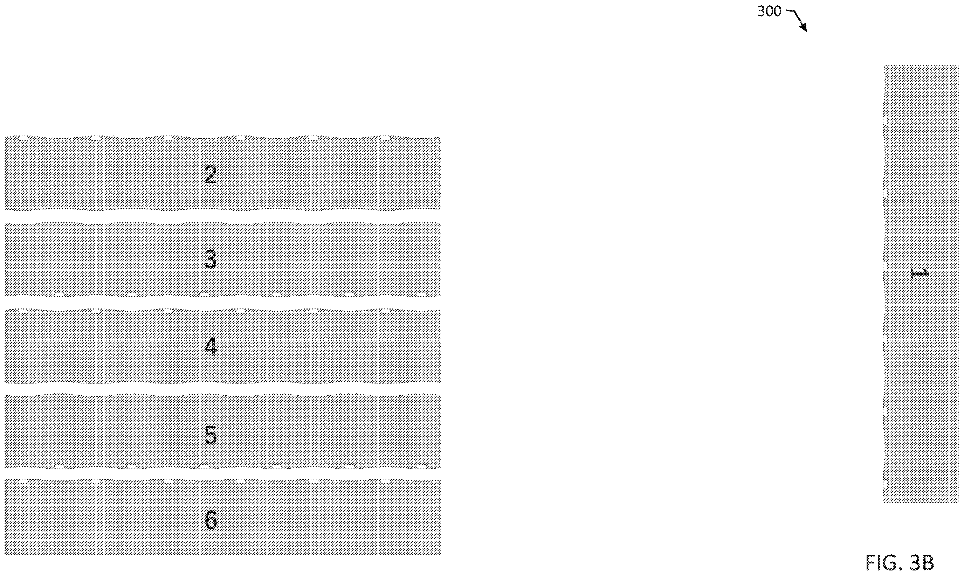

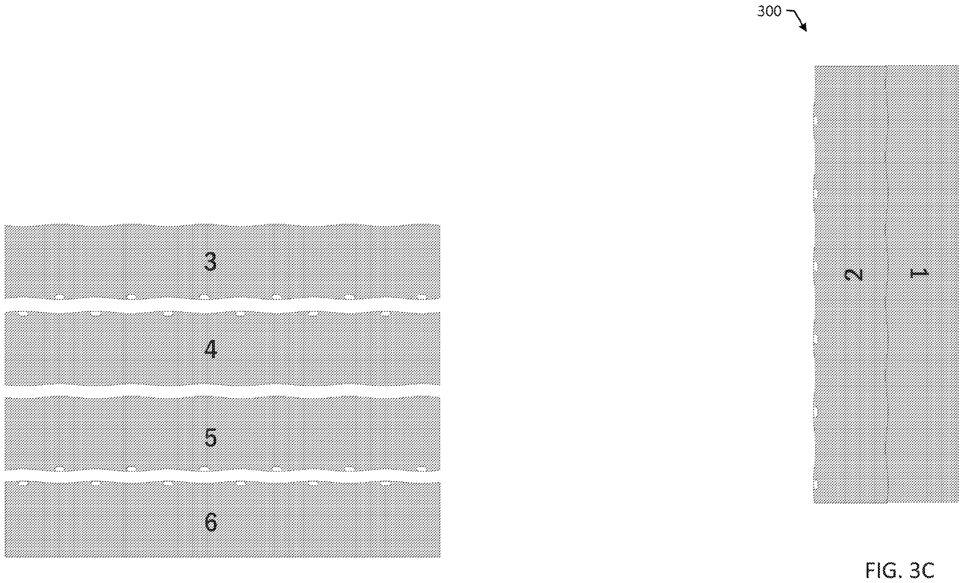

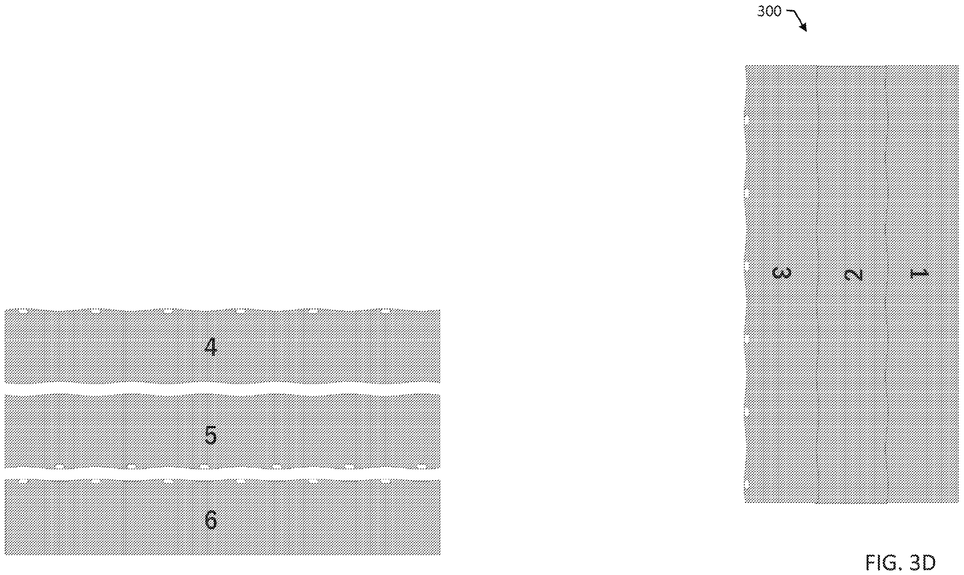

Figure 3A shows the wafer 200 after the wafer 200 has been cleaved along the non-linear scribe lines and before the robot has picked any of the remaining strips. Figure 3B shows the solar device 300 after the robot has picked and placed strip 1 (e.g., onto a cure belt). Figure 3C shows the solar device 300 after the robot has picked strip 2, rotated strip 2 by 180 degrees, and shingled strip 2 onto strip 1. Figure 3D shows the solar device 300 after the robot has picked strip 3 and shingled strip 3 onto strip 2.

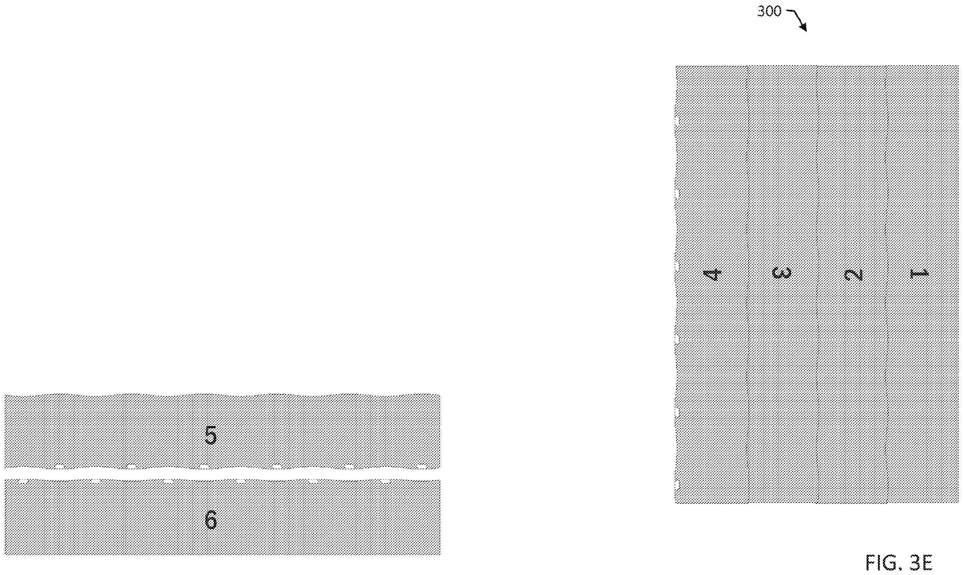

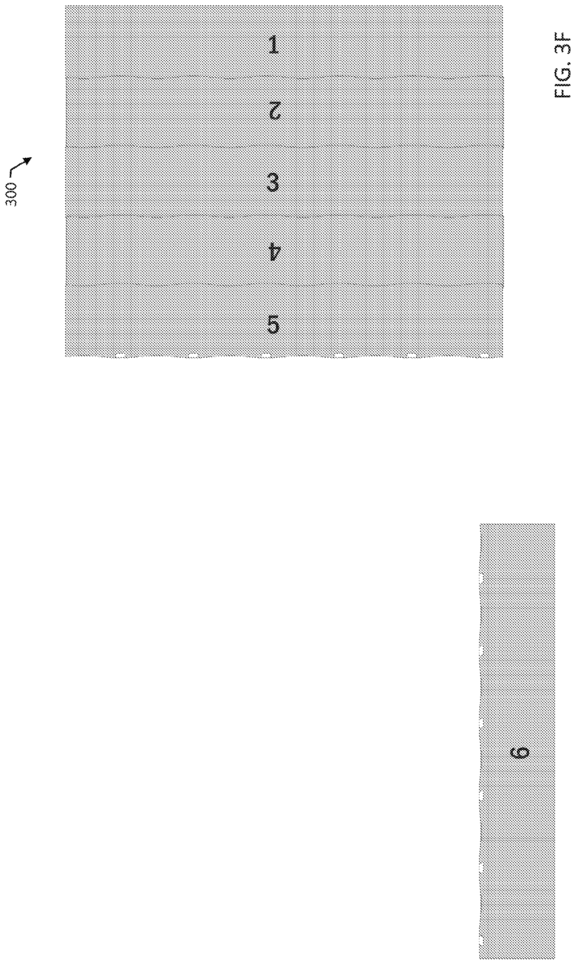

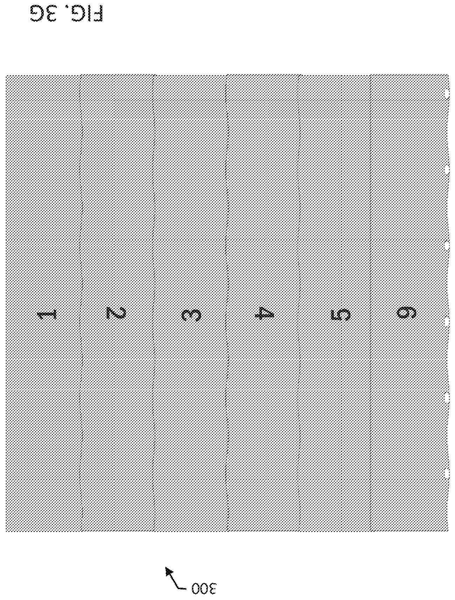

Figure 3E shows the solar device 300 after the robot has picked strip 4, rotated strip 4 by 180 degrees, and shingled strip 4 onto strip 3. Figure 3F shows the solar device 300 after the robot has picked strip 5 and shingled strip 5 onto strip 4. Figure 3G shows the solar device 300 after the robot has picked strip 6, rotated strip 6 by 180 degrees, and shingled strip 6 onto strip 5. The resulting solar device 300 has a configuration corresponding to the solar device 100 depicted in Figures 1A-B.

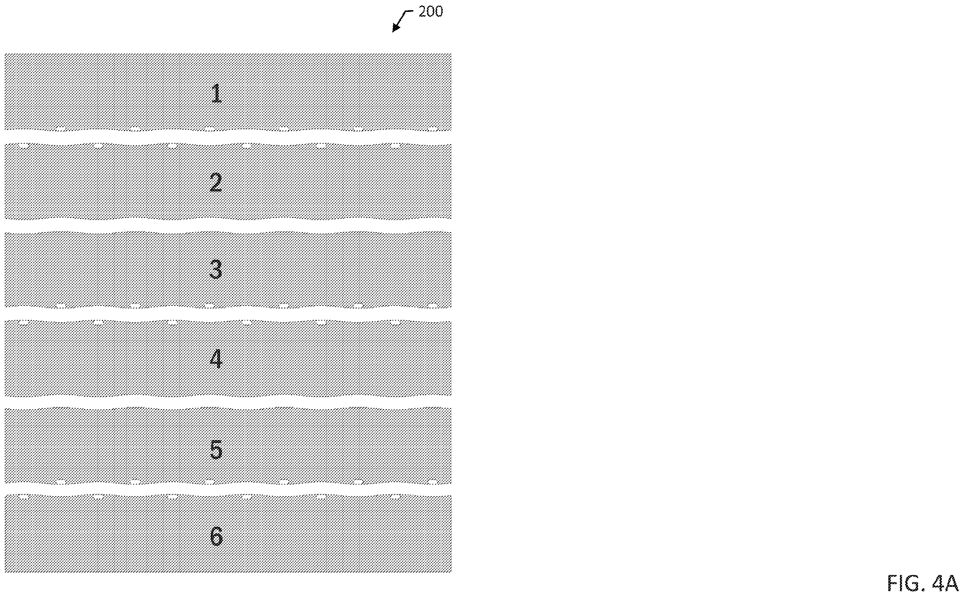

Figures 4A-G illustrate another example process for producing a solar device from the wafer 200 of Figures 2A-B, not being part of the invention. The process can be performed, e.g., by a manufacturing system including first and second shingling robots. The wafer 200 is scribed, paste printed, and cleaved along the non-linear scribe lines. Then the robots arrange the remaining solar cell strips in a shingled manner with the ends of adjacent strips overlapping along the non-linear edges. The robots pick every other strip and produce first and second solar devices 402 and 404, which can avoid the 180 degree rotation illustrated in Figures 3A-G.

For purposes of illustration, each of the strips is labelled with a number from one to six. As shown in Figures 4A-G, the numbers rotate with the strips (i.e., the numbers maintain their orientation with respect to the strips) to illustrate the placement for shingling along the non-linear edges. The strips that remain after cleaving are shown on the left side, and the strips that have been picked and placed are shown on the right side.

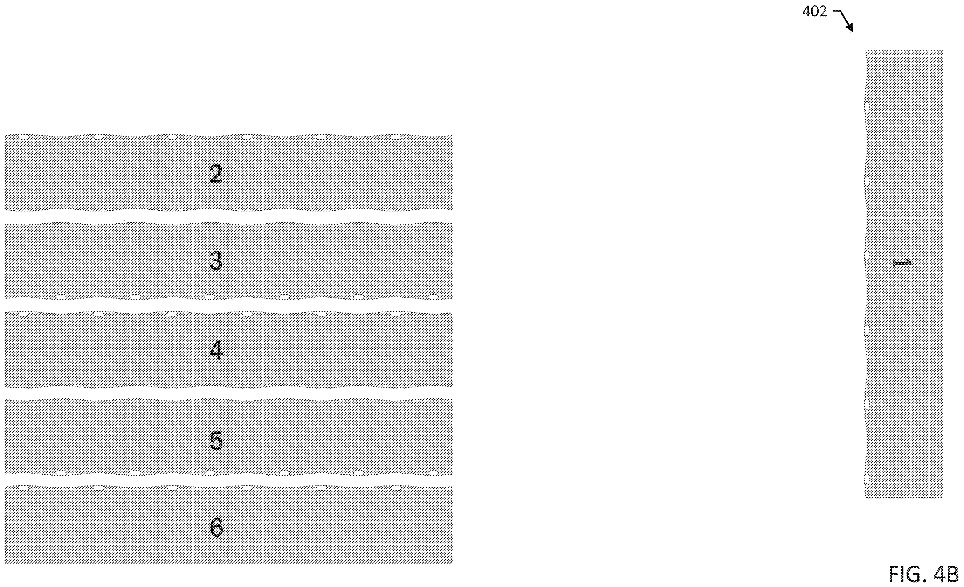

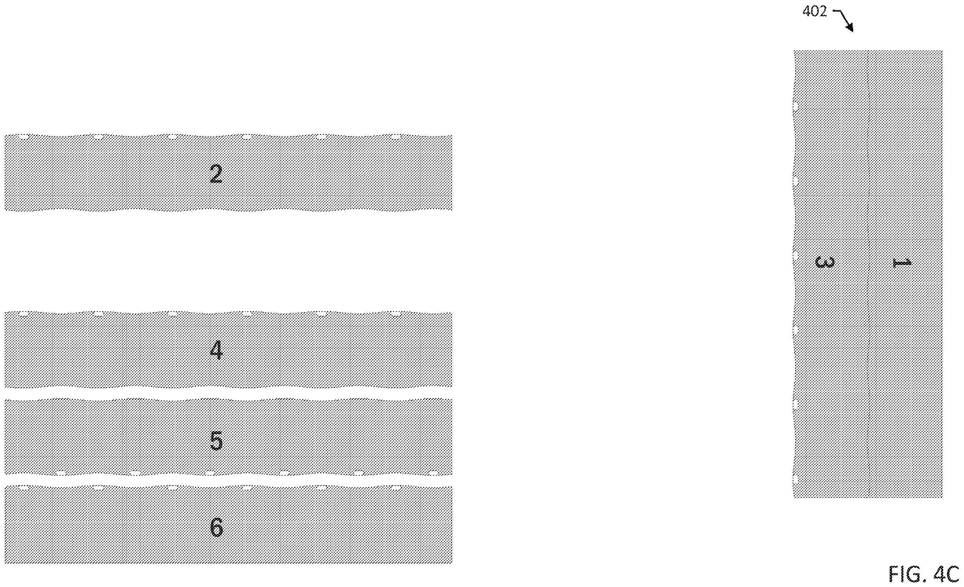

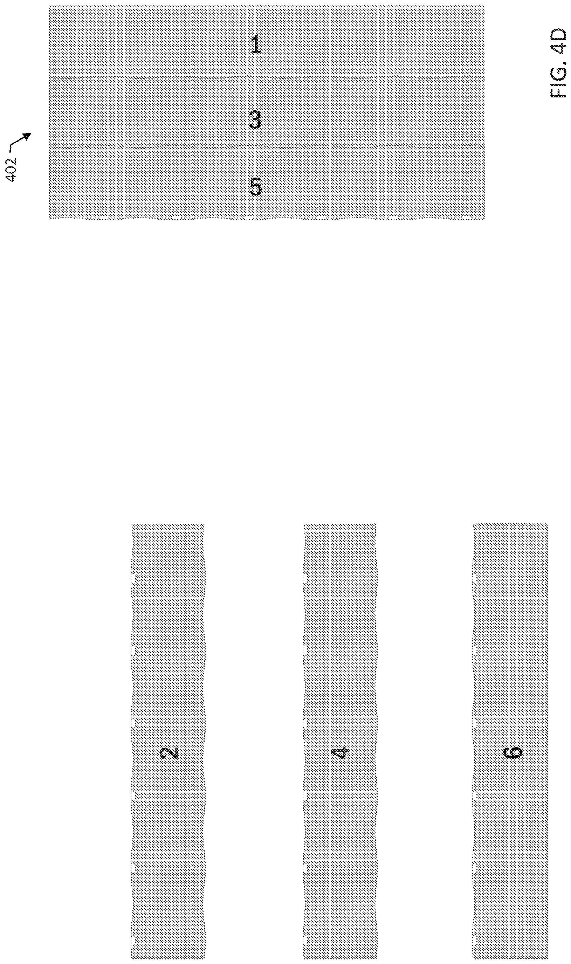

Figure 4A shows the wafer 200 after the wafer 200 has been cleaved along the non-linear scribe lines and before the robots have picked any of the remaining strips. Figure 4B shows the first solar device 402 after the first robot has picked and placed strip 1 (e.g., onto a cure belt). Figure 4C shows the first solar device 402 after the first robot has picked strip 3 and shingled strip 3 onto strip 1. Figure 4D shows the first solar device 402 after the robot has picked strip 5 and shingled strip 5 onto strip 3.

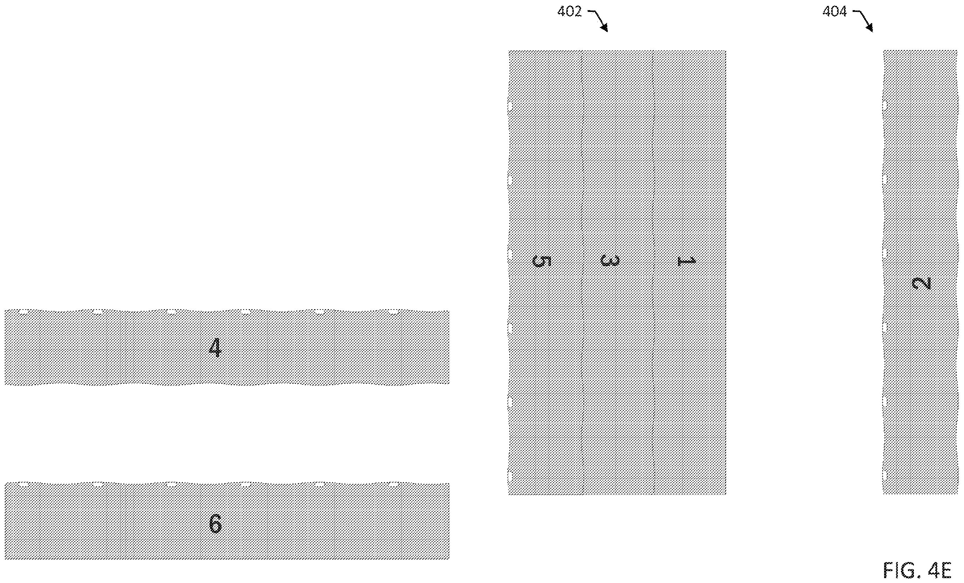

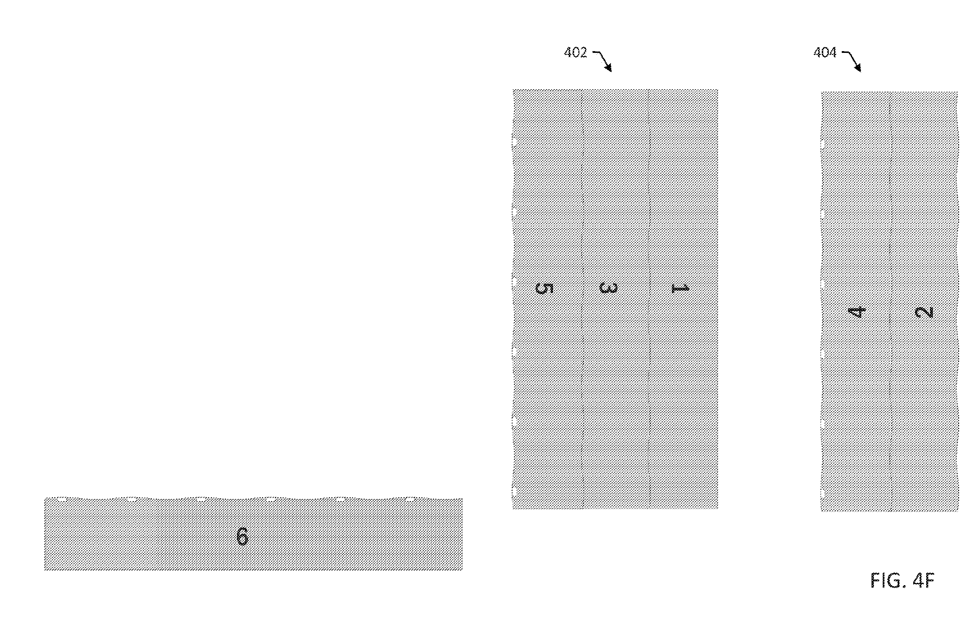

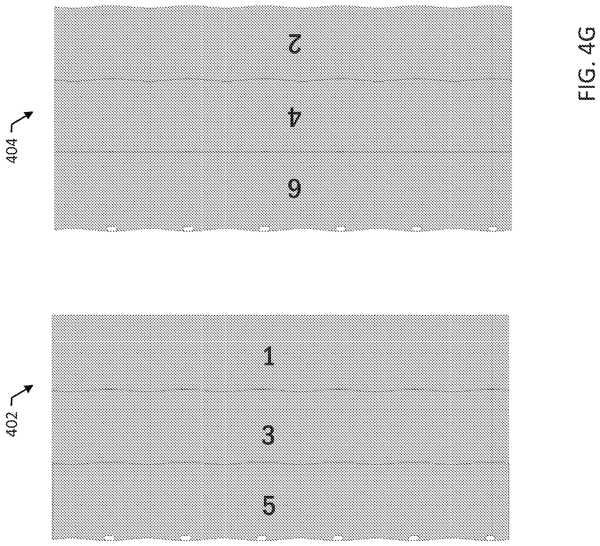

Figure 4E shows the second solar device 404 after the second robot has picked and placed strip 2 (e.g., onto a cure belt). Figure 4F shows the second solar device 404 after the robot has picked strip 4 and shingled strip 4 onto strip 2. Figure 4G shows the second solar device 404 after the robot has picked strip 6 and shingled strip 6 onto strip 4. The process can be continued with one or more other wafers to build the solar devices 402 and 404 to a particular number of strips.

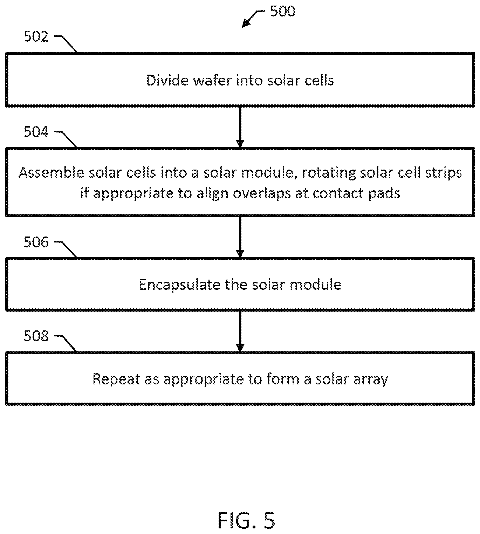

Figure 5 is a flow diagram of an example method 500 for producing a solar device of solar cells arranged in a shingled manner with the ends of adjacent solar cells overlapping along non-linear edges, not being part of the invention. The method 500 includes dividing 502 a photovoltaic wafer, such as the example wafer 200 of Figures 2A-B, to form solar cells. For example, dividing the wafer can include scribing (e.g., laser scribing) the wafer to form non-linear scribe lines as described above with reference to Figures 2A-B and cleaving the wafer along the non-linear scribe lines.

The method 500 can optionally include testing and sorting the resulting solar cells according to their current-voltage performance. In some examples, the method 500 includes using solar cells with matching or approximately matching current-voltage performance in the same solar device or in the same row of series connected modules.

The method 500 includes assembling 504 the solar cells in a shingled manner with the ends of adjacent solar cells overlapping along non-linear edges. For example, the method 500 can include rotating, by a robot, every other strip as described above with reference to Figures 3A-G. In another example, the method 500 can include picking, by two robots, every other strip and producing two solar devices as described above with reference to Figures 4A-G.

Assembling the solar cells can include disposing a conductive adhesive bonding material onto contact pads between overlapping portions of adjacent solar cells, e.g., before or after dividing the wafer. Disposing the conductive adhesive can include, e.g., ink jet printing or screen printing. In some examples, assembling the solar cells can include applying heat and pressure to cure or partially cure the conductive adhesive bonding material between the solar cells in the solar device.

In some examples, as each additional solar cell is added to the solar device, the conductive adhesive bonding material between the newly added solar cell and its adjacent overlapping solar cell (which has already been placed) is cured or partially cured, before the next solar cell is added to the solar device. In another example, assembling the solar cells includes positioning more than two solar cells or all solar cells in the desired overlapping manner before the conductive adhesive bonding material is cured or partially cured.

The method 500 optionally includes encapsulating 506 the solar device into a layered structure including encapsulant material, a transparent front sheet, and a back sheet. The layered structure can include, e.g., a first layer of encapsulant on a glass substrate, with the shingled solar cells arranged sun-side down on the first layer of encapsulant; a second layer of encapsulant on the shingled solar cells; and a back sheet on the second layer of encapsulant. Any other appropriate arrangement may also be used. The method 500 optionally includes repeating 508 the dividing 502, assembling 504, and encapsulating 506 to form a number of solar devices and assembling the solar devices into a solar array, e.g., the solar array 170 of Figure 1D.

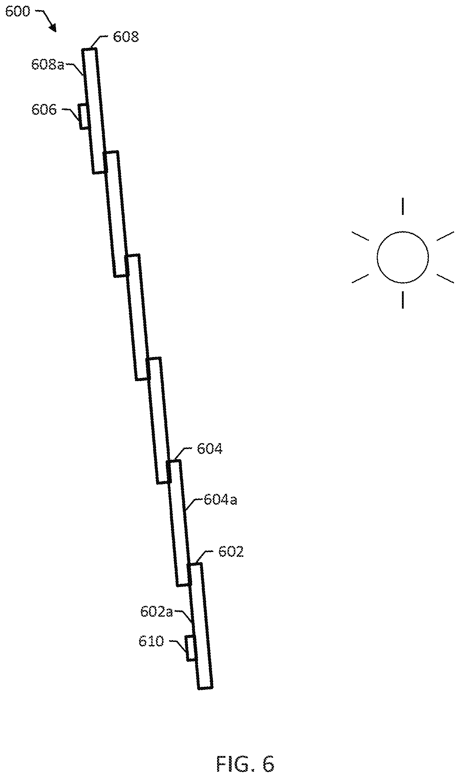

Figure 6 illustrates an example solar device 600 of solar cells arranged in a shingled manner with a sacrificial solar cell 602, not being part of the invention. The sacrificial solar cell 602 overlaps a front surface 604a of an end one 604 of the adjacent solar cells and is conductively bonded to the front surface 604a of the end one 604 of the adjacent solar cells to electrically and mechanically connect a rear surface 602a of the sacrificial solar cell 602 in series with the adjacent solar cells.

The solar device includes a first conductive lead 606 conductively bonded to a rear surface 608a of a solar cell 608 located at an opposite end of the solar device 600 from the sacrificial solar cell 602. The first conductive lead is configured to provide, during operation of the solar device 600, a first electrical output from the solar device 600 having a first polarity. The solar device 600 also includes a second conductive lead 610 conductively bonded to the rear surface 602a of the sacrificial solar cell 602 and configured to provide, during operation of the solar device 600, a second electrical output from the solar device 600 having a second polarity opposite from the first polarity.

The sacrificial cell 602 is configured, by virtue of the second conductive lead 610 being conductively bonded to the rear surface 602a of the sacrificial solar cell 602, to contribute no power to a module-level electrical output of the solar device 600 during operation of the solar device 600. For example, the sacrificial cell 602 can be "sacrificial" in the sense that, in operation of the solar device 600, the sacrificial cell 602 can be manufactured by a same process as the other solar cells yet contribute no power because electrical contact is made only to the rear surface 602a of the sacrificial solar cell 602.

In some examples, the sacrificial solar cell 602 lacks a front surface metallization that is present on other solar cells in the solar device 600. In some other examples, the sacrificial solar cell and the other solar cells in the solar device 600 each have identical front and rear surface metallization. In some examples, the sacrificial solar cell 602 is a rejected solar cell that fails a screening test passed by other solar cells in the solar device 600.

The sacrificial cell 602 can have an outer edge positioned away from the solar device 600 that includes protrusions lying in the plane of the sacrificial cell that protrude away from the solar device 600 along the line of the solar device 600, and rear surface contact pads each of which is located on a rear surface of a corresponding protrusion. The second conductive lead 610 can then be bonded to the contact pads. Examples of sacrificial solar cells and solar devices including sacrificial solar cells are described in U.S. Provisional Application 62/267,101, filed on December 14, 2015, which is hereby incorporated by reference.

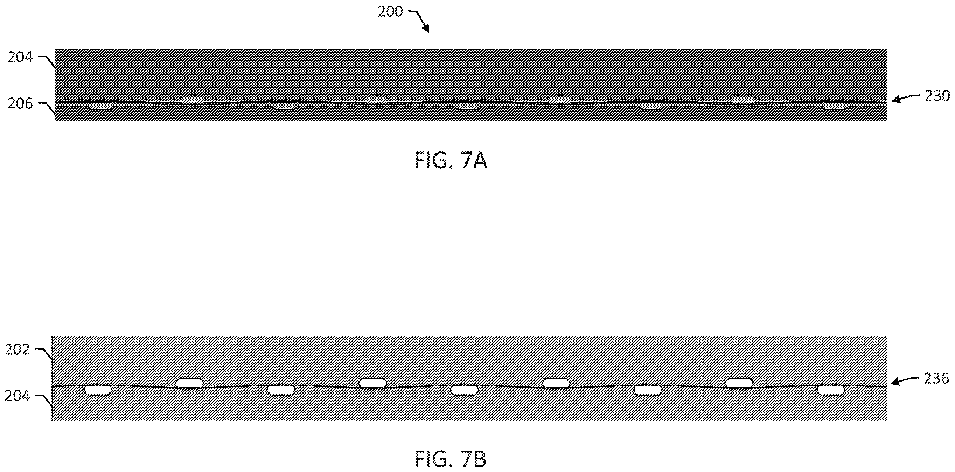

Figures 7A-C illustrate a conductive busbar that can be used in shingled solar cell devices, not being part of the invention. Figure 7A shows a front view of a portion of the wafer 200 of Figures 2A-B. An interior row 230 of contact pads follows a scribe line between two regions 204 and 206 of the wafer 200. Conductive busbars are disposed on the front side of the wafer 200.

Figure 7B shows a back view of a portion of the wafer 200. An interior row 236 of contact pads follows a scribe line between two regions 202 and 204 of the wafer. The back of the wafer 200 lacks a conductive busbar; however, when the wafer is diced and assembled, the back contact pads will contact corresponding front contact pads so that the back contact pads and front contact pads are electrically connected. In some examples, the back contact pads have a larger area than the front contact pads.

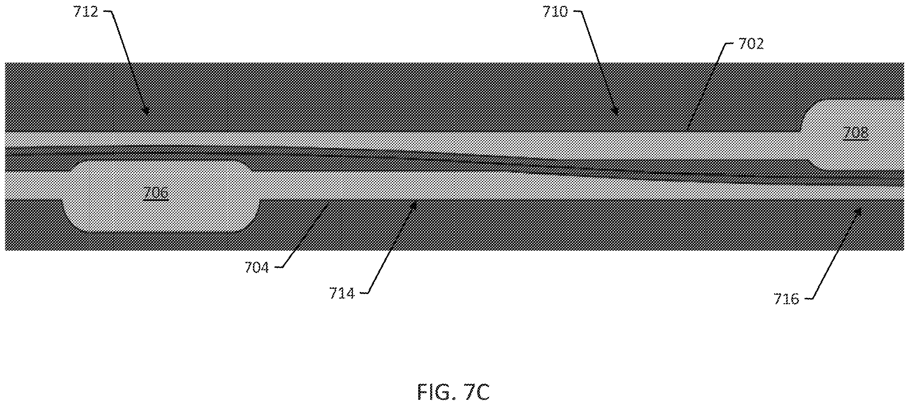

Figure 7C shows a closer view of the front of the wafer 200 to illustrate the conductive busbars. A top busbar 702 electrically connects the contact pads above the scribe line, and a bottom busbar 704 busbar electrically connects the contact pads below the scribe line. The conductive busbars can be formed of, e.g., silver that is disposed on the wafer.

The conductive busbars have a width that varies along the scribe line. For example, the top busbar 702 has a width that tapers from a full width in a region 710 near a top contact pad 708 to a narrow width in a region 712 between contact pads above the scribe line. The bottom busbar 704 has a width that tapers from a full width in a region 714 near a bottom contact pad 706 to a narrow width in a region 716 between contact pads above the scribe line.

In some examples, the width of each conductive busbar 702 and 704 varies to maintain a constant spacing between the conductive busbar and the scribe line. The width of the conductive busbars 702 and 704 can be formed to maintain at least a specified minimum thickness for current carrying capacity. As illustrated, the conductive busbars 702 and 704 have one edge that is flat and another edge that follows the scribe line to vary the width of the conductive busbars 702 and 704.

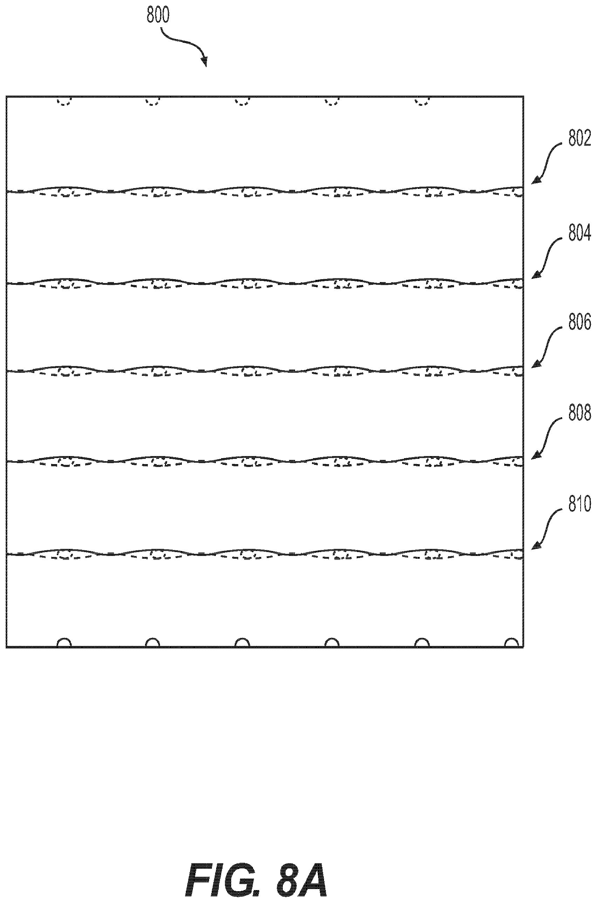

Figures 8A-B illustrate shingled solar device 800 according to the invention having conductive busbars that vary in width. The solar device 800 can be made using the wafer 200 of Figure 2 and the conductive busbars described with reference to Figures 7A-C. The solar device 800 can be assembled as described with reference to Figures 4A-G and Figure 5.

Figure 8A is a back view of the solar device 800. For purposes of illustration, Figure 8A shows edges of the solar cells that face the viewer as dark lines, and Figure 8A shows edges of solar cells that are hidden behind other solar cells in overlapping regions as light lines, as if the solar cells were transparent in those regions (i.e., Figure 8A is an "x-ray" view). In this view, the viewer can see contact pads as circular shapes in the regions where adjacent solar cells overlap.

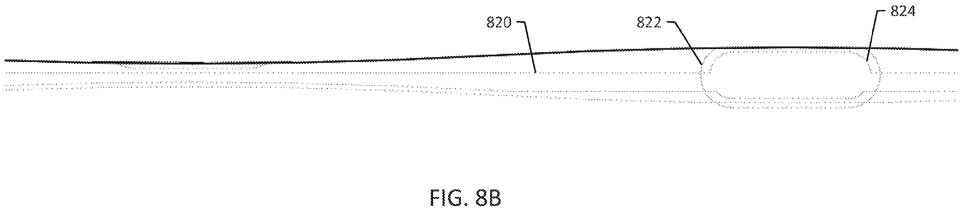

The solar device 800 includes rows of contact pads 802, 804, 806, 808, and 810. The contact pads within each row include back contact pads electrically contacted to front contact pads. The front contact pads of each row are electrically connected to other contact pads in the row by conductive busbars. Figure 8B shows a closer view of an example conductive busbar 820, back contact pad 822, and front contact pad 824.

As assembled in a shingle manner, the conductive busbars are not visible from the front of the solar device 800. Each conductive busbar is fully underneath an overlapping region of adjacent solar cells. The contact pads are also fully underneath the overlapping region of adjacent solar cells. The conductive busbars are narrowest in width where the overlaps between adjacent solar cells is the smallest.

Solar device 800 would generate less power if the conductive busbars were exposed. Varying the width of the conductive busbars so that the conductive busbars are fully underneath overlapping regions of adjacent solar cells can improve the power output of the solar device 800. Moreover, varying the width of the conductive busbars can allow for the adjacent solar cells to be placed with smaller areas of strip overlap, which can also improve the power output of the solar device 800.

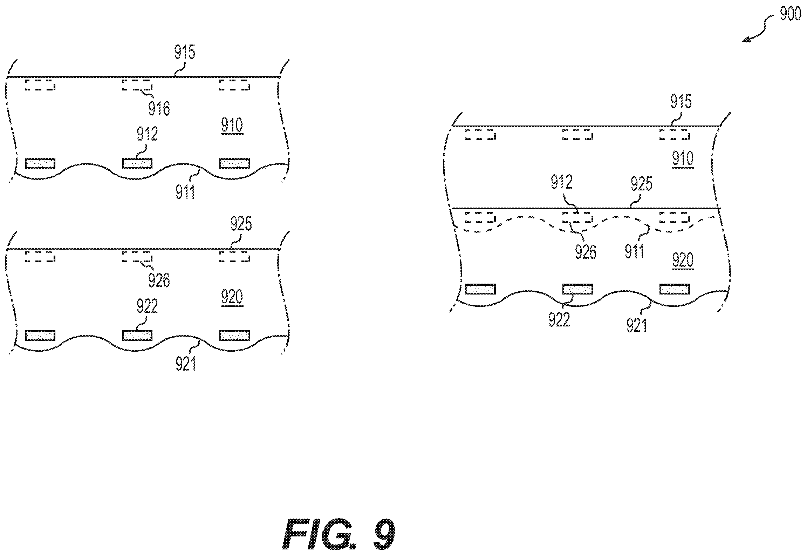

Figure 9 show a solar device example 900 not being part of the invention. The solar device 900 operates similarly to the solar device 100 and also utilizes certain components that are identical or equivalent to those used in the solar device 100; the description of these components has been provided above, and will be omitted here for clarity purposes.

The solar device 900 includes a plurality of solar cells, such as a first solar cell 910, a second solar cell 920 and the like, arranged in a shingled manner to connect in series. A solar cell includes two interconnecting edges to connect the solar cell to neighboring solar cells in series. Specifically, in an example, the first solar cell 910 is formed of a plane silicon structure that has two surface sides, such as a front side and a back side. The front side of the first solar cell 910 is configured to face a light incoming direction to receive energy from a light source. Further, the first solar cell 910 has a first interconnecting edge 911 of a non-linear shape with protruding portions. The first solar cell 910 is configured to include one or more contact pads 912 disposed on the front side in the protruding portions. The second solar cell 920 is also formed of a plane silicon structure that has the front side and the back side. The second solar cell 920 is configured to overlap with the first solar cell 910 at the protruding portions on top of the front side of the first solar cell 910. The front side of the second solar cell 920 also faces the light incoming direction. The second solar cell 920 includes second one or more contact pads 926 that are disposed on the back side of second solar cell 920. The first one or more contact pads 912 and the second one or more contact pads 926 are aligned and connected to electrically couple the first solar cell 910 and the second solar cell 920.

In the Figure 9 example, not being part of the invention, the second solar cell 920 is configured to have an interconnecting edge 925 of a linear shape to overlap the first solar cell 910 at the protruding portions. However, it noted that the second solar cell 920 can be configured in accordance with the invention to have the interconnecting edge 925 of a non-linear shape to overlap the first solar cell 910 at the protruding portions.

It is noted that the protruding portions can have any suitable shape. In the Figure 9 example, the first interconnecting edge 911 has a sinusoidal shape with the protruding portions. The first interconnecting edge 911 can be configured to have other shape, such as square protruding portions, triangle protruding portions, that are shown in the Figure 2D.

In the Figure 9 example, not being part of the invention, the first solar cell 910 and the second solar cell 920 have identical configuration. Specifically, the first solar cell 910 has the first interconnecting edge 911 of the non-linear shape, and a second interconnecting edge 915 of the linear shape. The first interconnecting edge 911 and the second interconnecting edge 915 extend in the same directions. The first solar cell 910 has contact pads 912 disposed along the first interconnecting edge 911 at the protruding portions on the front side, and has contact pads 916 disposed along the second interconnecting edge 915 on the back side.

Similarly, the second solar cell 920 has a first interconnecting edge 921 of the non-linear shape, and the second interconnecting edge 925 of the linear shape. The first interconnecting edge 921 and the second interconnecting edge 925 extend in the same directions. The second solar cell 920 has contact pads 922 disposed along the first interconnecting edge 921 at the protruding portions on the front side, and has contact pads 926 disposed along the second interconnecting edge 925 on the back side.

In an example, to assemble the solar device 900, the second interconnecting edge 925 of the second solar cell 920 overlaps the first interconnecting edge 911 of the first solar cell 910 on the front side. The contact pads 926 on the back side of the second solar cell 920 are aligned and then electrically connected with the contact pads 912 on the front side of the first solar cell 910. In an embodiment, multiple solar cells of the same shape are coupled in series in the similar configuration as the first solar cell 910 and the second solar cell 920.

It is noted that edges of the first solar cell 910 and the second solar cell 920 can have different shape. In an example, the second interconnecting edge 915 of the first solar cell 915 can have non-linear shape. In another example, the first interconnecting edge 921 of the second solar cell 920 can have linear shape. In another example, other edges (not shown) of the first solar cell 910 and the second solar cell 920 can have any suitable shape, such a linear shape, a non-linear shape, and the like.

It is noted that, for illustration, Figure 9 is not drawn to scale. In an example, a strip has 1:6 width to length ratio. For example, when the length is about 156 mm, the width is about 26 mm. In an example, a thickness of a strip is about 160 microns. Further, in an example, when the contact pads 926 on the back side of the second solar cell 920 are aligned with the contact pads 912 on the front side of the first solar cell 910, the largest overlapping width is about 2 mm, and the smallest overlapping width can be 0 mm or larger than 0 mm in an example.

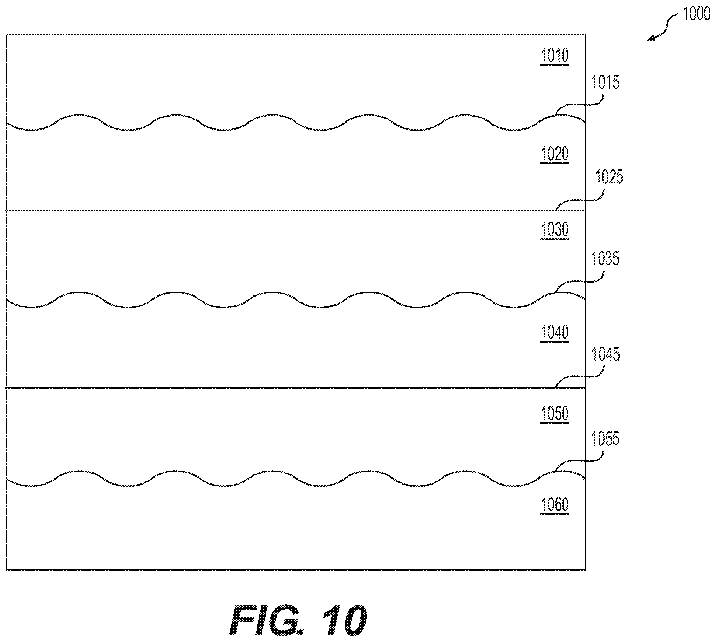

Figure 10 shows a photovoltaic wafer 1000 not being part of the invention. The photovoltaic wafer 1000 is similarly configured as the photovoltaic wafer 200. In the Figure 10 example, the photovoltaic wafer 1000 has a rectangular shape. It is noted that, in another example, the photovoltaic wafer 1000 can have other suitable shape, such as a circular shape, a trapezoid shape and the like.

In an embodiment, the photovoltaic wafer 1000 can be partitioned into N strips according to scribe lines, and N is even number. In an example, the strips are of the same shape, such as a pseudo rectangular shape with two long edges and two short edges. In an example, the two long edges are interconnecting edges, one of the interconnecting edges is a linear edge and the other interconnecting edge is a non-linear edge. In an embodiment, the photovoltaic wafer 1000 is partitioned by scribe lines that alternate between non-linear scribe line and linear scribe line to generate the strips. Thus, in an example, the photovoltaic wafer 1000 is partitioned by N/2 non-linear scribe lines and N/2-1 linear scribe lines in an alternating series.

Specifically, in the Figure 10 example, the photovoltaic wafer 1000 is partitioned into 6 strips 1010-1060 by cutting lines (scribe lines) 1015, 1025, 1035, 1045 and 1055. Among the cutting lines, cutting lines 1015, 1035 and 1055 are sinusoidal lines and lines 1025 and 1045 are straight lines.

It is noted that, in an example, solar cells, such as the first solar cell 910, second solar cell 920 and the like are implemented using the strips 1010-1060 with contact pads on the front side and back side. The solar cells are then coupled together in the same manner as shown in Figure 9.

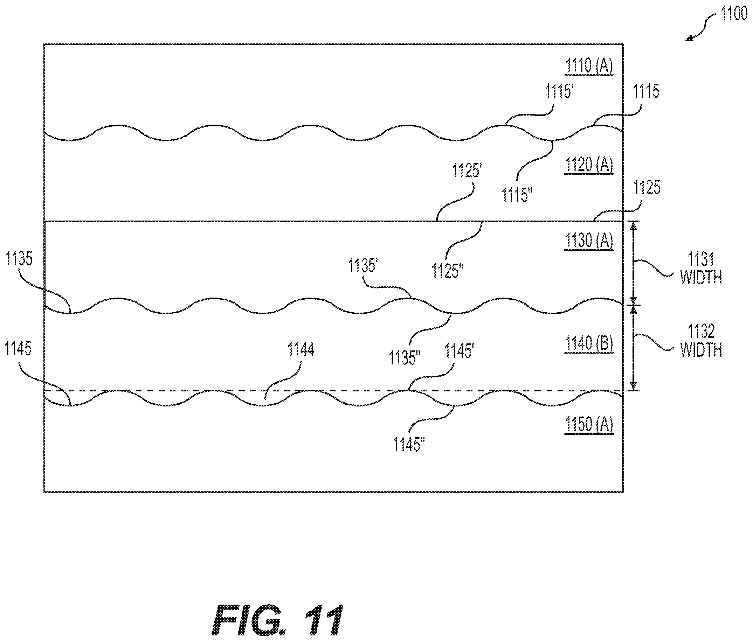

Figure 11 shows another photovoltaic wafer 1100 not being part of the invention. The photovoltaic wafer 1100 is similarly configured as the photovoltaic wafer 200. In the Figure 11 example, the photovoltaic wafer 1100 has a rectangular shape. It is noted that, in another example, the photovoltaic wafer 1100 can have other suitable shape, such as a circular shape, a trapezoid shape and the like.

In an embodiment, the photovoltaic wafer 1100 can be partitioned into N number of strips according to scribe lines, and N is an odd number. In an example, N-1 strips are of the same shape, and each has a linear interconnecting edge and a non-linear interconnecting edge similar to the strips in Figure 10. One specific strip has different shape from the other strips. In an example, the specific strip has two non-linear interconnecting edges. In the example, the photovoltaic wafer 1100 is partitioned by scribe lines that alternate between non-linear scribe line and linear scribe line, and one more non-linear scribe line. Thus, in an example, the photovoltaic wafer 1000 is partitioned by (N+1)/2 non-linear scribe lines and (N-3)/2 linear scribe lines in an alternating series.

In another example, the specific strip has two linear interconnecting edges. In an example, the photovoltaic wafer 1100 is partitioned by scribe lines that alternate between non-linear scribe line and linear scribe line. Thus, in an example, the photovoltaic wafer 1000 is partitioned by (N-1)/2 non-linear scribe lines and (N-1)/2 linear scribe lines in an alternating series.

Specifically, in the Figure 11 example, the photovoltaic wafer 1100 is partitioned into 5 strips 1110-1150 by cutting lines (scribe lines) 1115, 1125, 1135, and 1145. Among the cutting lines, lines 1115, 1135 and 1155 are sinusoidal lines and line 1025 is a straight line. Thus, strips 1110, 1120, 1130 and 1150 have the same shape (shape A) with a non-linear interconnecting edge and a linear interconnection edge, and the strip 1140 has a different shape (shape B) with two non-linear interconnecting edges. In the Figure 11 example, the strip 1140 has the same width 1132 as the width 1131 of the other strips, and has excess area, as shown by 1144, compared to the other strips due to the additional non-linear interconnecting edge.

It is noted that, in an example, solar cells, such as the first solar cell 910, second solar cell 920 and the like are implemented using the strips 1110-1150 with contact pads on the front side and back side. The solar cells are then coupled together in the same manner as shown in Figure 9.

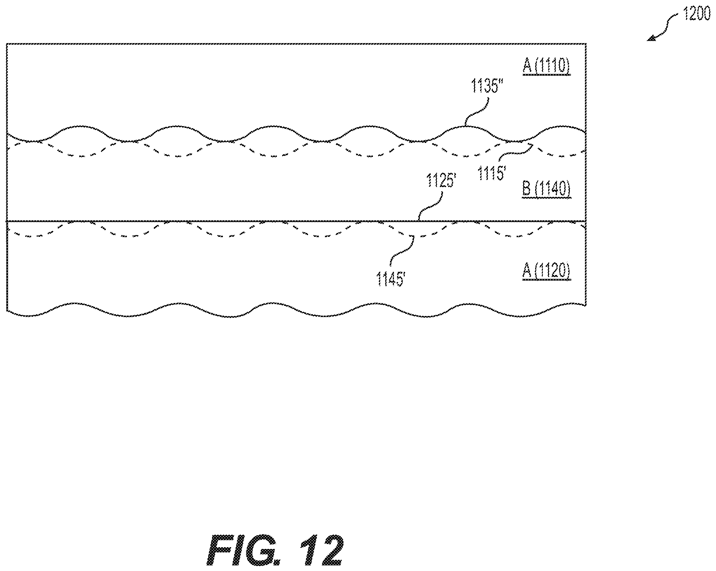

Figure 12 shows an assembly example 1200 of strips having both shape A and shape B not being part of the invention. In the Figure 12 example, a first strip having shape A, such as the strip 1110, is disposed with the front side up. Then, a second strip having shape B, such as the strip 1140, is disposed to overlap the first strip 1110 on top of the non-linear interconnecting edge (e.g., 1115') of the first strip 1110. The contact pads of the strip 1110 and the strip 1140 are aligned and connected to electrically couple the two strips 1110 and 1140 together. Further, a third strip having shape A, such as the strip 1120, is disposed to overlap the second strip 1140 on top of the other non-linear interconnecting edge (e.g., 1145') of the second strip 1140. The contact pads of the strip 1140 and the strip 1120 are aligned and connected to electrically couple the two strips 1140 and 1120 together. Thus, the strips 1110, 1140 and 1120 are electrically connected in series.

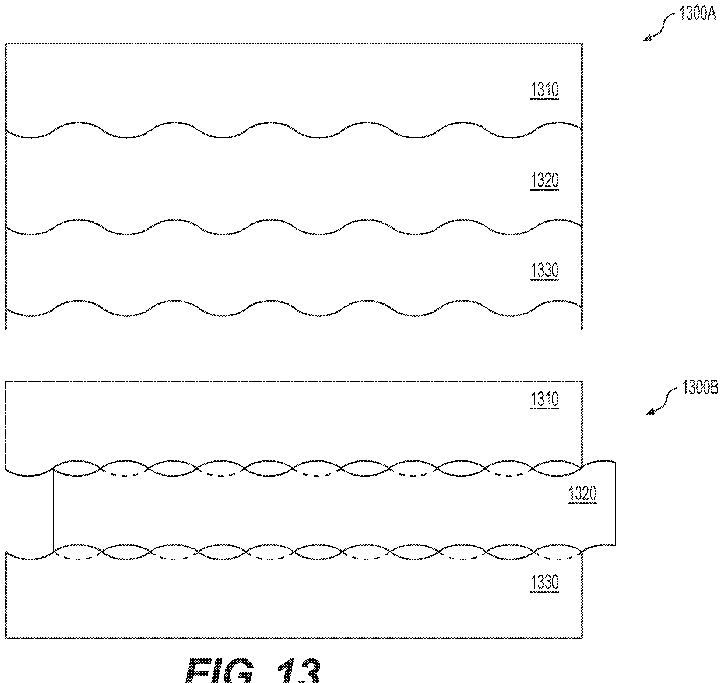

Figure 13 shows an example for arranging solar cells not being part of the invention. In the Figure 13 example, a photovoltaic wafer 1300A is scribed into strips, such as strips 1310-1330 as shown, similarly to the wafer 200 described above.

Further, in the Figure 13 example, some of the strips, such as every other strip, are shifted, for example by ½ cycle of the sinusoidal scribe line, such that neighboring strips are overlapped at the protruding portions as shown by 1300B. Then, contact pads at the back side of a strip can be aligned and electrically connected with contact pads at the front side of the neighboring strip.

## Claims

1. A solar device, comprising:
a first solar cell (102) configured to have a first long edge (102d) of a non-linear shape with
protruding portions and includes first contact pads (116a-116f, 802)
arranged in respective peaks of the protruding portions, wherein the first long edge extends in a length direction between respective ends of two opposing short edges that extend in a width direction; and
a second solar cell (104) configured to have a long edge (104c) to overlap with the first long
edge (102d) at the protruding portions of the first solar cell (102), the long edge (104c) of the
second solar cell is of a non-linear shape with protruding portions and including second contact pads (116a-116f, 802) in respective peaks of the protruding portions
and that are aligned with the first contact pads (116a-116f, 802) to electrically connect the first
solar cell (102) and the second solar cell (104), thereby the first and second
solar cells are arranged in a shingled manner such that an overlapping area (114) in the width
direction is larger over the contact pads (116a-166f, 802) than at points between the contact pads

2. The solar device of claim 1, wherein the first long edge has a sinusoidal shape.

3. The solar device of claim 1, wherein the second solar cell is configured to overlap on top of a front side (102a) of the first solar cell at the protruding portions, the front side of the first solar cell is configured to face a light incoming direction.

4. The solar device of claim 1, wherein the first solar cell is configured to have a second long edge of a linear shape, the second long edge extends in same directions as the first long edge.

5. The solar device of claim 1, wherein the first solar cell is configured to have a second long edge of a non-linear shape, the second long edge extends in the same length direction as the first long edge.

6. The solar device of claim 1, wherein the first solar cell is configured to have a second long edge that overlaps a third solar cell at protruding portions of a nonlinear edge of the third solar cell, and the first solar cell and the third solar cell are electrically connected by aligned contact pads positioned at overlapped portions of the first solar cell and the third solar cell.

7. The solar device according to claim 1, wherein
each of the first solar cell and the second solar cell having a plane silicon structure with a front side and a back side, the front side being configured to face a light incoming direction to receive energy from a light source;
the first long edge is of the plane silicon structure; and
the first contact pads are arranged in the protruding portions on the front side the first contact pads are configured to align with the second contact pads on the back side of the second solar cell to electrically connect the first solar cell with the second solar cell.

8. The solar device of claim 7, wherein the first long edge has a sinusoidal shape.

9. The solar device of claim 7, further comprising: a second long edge of the plane silicon structure configured to have a linear shape, the second long edge extending in same directions as the first long edge.

10. The solar device of claim 7, further comprising:
a second long edge of the plane silicon structure configured to have a nonlinear shape,
the second long edge extending in same directions as the first long edge.

11. The solar device of claim 7, further comprising: other contact pads arranged on the back side of the first solar cell along a second long edge of the plane silicon structure, the other contact pads are configured to align with contact pads on a front side of a third solar cell to electrically connect the first solar cell with the third solar cell.

12. A method, comprising:
forming a first solar cell (102) that has a first long edge (102d) of a non-linear shape with
protruding portions and includes first contact pads (116a-116f, 802)
arranged in respective peaks of the protruding portions, wherein the first long edge extends in a length direction between respective ends of two opposing short edges that extend in a width direction;
forming a second solar cell (104) that has a long edge (104c) of a non-linear shape with
protruding portions and including second contact pads (116a-116f, 802) in respective peaks of the protruding portions;
overlapping the second solar cell with the first solar cell at the protruding portions: and
aligning the first one or more contact pads with the second contact pads to electrically connect the first solar cell and the second solar cell, thereby the first and second solar cells are arranged in a shingled manner such that an overlapping area (114) in the width
direction is larger over the contact pads than at points between the contact pads.

13. The method according to claim 12, wherein,
each of the first solar cell and the second solar cell having a plane silicon structure, the plane silicon structure having a front side and a back side, the front side being configured to face a light incoming direction to receive energy from a light source, the first long edge is of the plane silicon structure,
the method further comprising disposing the first contact pads in the protruding portions on the front side, wherein the first contact pads are configured to align with the second contact pads on the back side of the second solar cell to electrically connect the first solar cell and the second solar cell.

## Patentansprüche

1. Solarvorrichtung, umfassend:
eine erste Solarzelle (102), die so konfiguriert ist, dass sie eine erste lange Kante (102d) mit nichtlinearer Form mit hervorstehenden Abschnitten aufweist und erste Kontaktflächen (116a bis 116f, 802) einschließt, die in jeweiligen Spitzen der hervorstehenden Abschnitte angeordnet sind, wobei sich die erste lange Kante in einer Längenrichtung zwischen jeweiligen Enden von zwei gegenüberliegenden kurzen Kanten erstreckt, die sich in einer Breitenrichtung erstrecken; und
eine zweite Solarzelle (104), die so konfiguriert ist, dass sie eine lange Kante (104c) aufweist, um sich mit der ersten langen Kante (102d)
an den hervorstehenden Abschnitten der ersten Solarzelle (102) zu überlappen, wobei die lange Kante (104c) der zweiten Solarzelle von nichtlinearer Form mit hervorstehenden Abschnitten ist und zweite Kontaktflächen (116a bis 116f, 802) in jeweiligen Spitzen der hervorstehenden Abschnitte einschließt, und die mit den ersten Kontaktflächen (116a bis 116f, 802) ausgerichtet sind, um die erste Solarzelle (102) und die zweite Solarzelle (104) elektrisch zu verbinden, wodurch die erste und die zweite Solarzelle in einer schindelartigen Weist angeordnet sind, sodass ein Überlappungsbereich (114) in der Breitenrichtung über den Kontaktflächen (116a bis 166f, 802) größer als an Punkten zwischen den Kontaktflächen ist.

2. Solarvorrichtung nach Anspruch 1, wobei die erste lange Kante eine Sinusform aufweist.

3. Solarvorrichtung nach Anspruch 1, wobei die zweite Solarzelle so konfiguriert ist, dass sie an der Oberseite einer Vorderseite (102a) der ersten Solarzelle an den hervorstehenden Abschnitten überlappt, wobei die Vorderseite der ersten Solarzelle so konfiguriert ist, dass sie einer Lichteinfallsrichtung zugewandt ist.

4. Solarvorrichtung nach Anspruch 1, wobei die erste Solarzelle so konfiguriert ist, dass sie eine zweite lange Kante einer linearen Form aufweist, wobei sich die zweite lange Kante in gleichen Richtungen wie die erste lange Kante erstreckt.

5. Solarvorrichtung nach Anspruch 1, wobei die erste Solarzelle so konfiguriert ist, dass sie eine zweite lange Kante einer nichtlinearen Form aufweist, wobei sich die zweite lange Kante in derselben Längenrichtung wie die erste lange Kante erstreckt.

6. Solarvorrichtung nach Anspruch 1, wobei die erste Solarzelle so konfiguriert ist, dass sie eine zweite lange Kante aufweist, die eine dritte Solarzelle an hervorstehenden Abschnitten einer nichtlinearen Kante der dritten Solarzelle überlappt, und die erste Solarzelle und die dritte Solarzelle durch ausgerichtete Kontaktflächen elektrisch verbunden sind, die an überlappten Abschnitten der ersten Solarzelle und der dritten Solarzelle positioniert sind.

7. Solarvorrichtung nach Anspruch 1, wobei sowohl die erste Solarzelle als auch die zweite Solarzelle eine ebene Siliciumstruktur mit einer Vorderseite und einer Rückseite aufweisen, wobei die Vorderseite so konfiguriert ist, dass sie einer Lichteinfallsrichtung zugewandt ist, um Energie von einer Lichtquelle zu empfangen; wobei die erste lange Kante von der ebenen Siliciumstruktur ist; und
die ersten Kontaktflächen in den hervorstehenden Abschnitten auf der Vorderseite angeordnet sind, wobei die ersten Kontaktflächen so konfiguriert sind, dass sie mit den zweiten Kontaktflächen auf der Rückseite der zweiten Solarzelle ausgerichtet sind, um die erste Solarzelle elektrisch mit der zweiten Solarzelle zu verbinden.

8. Solarvorrichtung nach Anspruch 7, wobei die erste lange Kante eine Sinusform aufweist.

9. Solarvorrichtung nach Anspruch 7, ferner umfassend:
eine zweite lange Kante der ebenen Siliciumstruktur, die so konfiguriert ist, dass sie eine lineare Form aufweist, wobei sich die zweite lange Kante in gleichen Richtungen wie die erste lange Kante erstreckt.

10. Solarvorrichtung nach Anspruch 7, ferner umfassend:
eine zweite lange Kante der ebenen Siliciumstruktur, die so konfiguriert ist, dass sie eine nichtlineare Form aufweist, wobei sich die zweite lange Kante in gleichen Richtungen wie die erste lange Kante erstreckt.

11. Solarvorrichtung nach Anspruch 7, ferner umfassend:
andere Kontaktflächen, die auf der Rückseite der ersten Solarzelle entlang einer zweiten langen Kante der ebenen Siliciumstruktur angeordnet sind, wobei die anderen Kontaktflächen so konfiguriert sind, dass sie mit Kontaktflächen auf einer Vorderseite einer dritten Solarzelle ausgerichtet sind, um die erste Solarzelle elektrisch mit der dritten Solarzelle zu verbinden.

12. Verfahren, umfassend:
Bilden einer ersten Solarzelle (102), die eine erste lange Kante (102d) einer nichtlinearen Form mit hervorstehenden Abschnitten aufweist und erste Kontaktflächen (116a bis 116f, 802) einschließt, die in jeweiligen Spitzen der hervorstehenden Abschnitte angeordnet sind, wobei sich die erste lange Kante in einer Längenrichtung zwischen jeweiligen Enden von zwei gegenüberliegenden kurzen Kanten erstreckt, die sich in einer Breitenrichtung erstrecken;
Bilden einer zweiten Solarzelle (104), die eine lange Kante (104c) einer nichtlinearen Form mit
hervorstehenden Abschnitte aufweist und zweite Kontaktflächen (116a bis 116f, 802) in jeweiligen Spitzen der hervorstehenden Abschnitte einschließt;
Überlappen der zweiten Solarzelle mit der ersten Solarzelle an den hervorstehenden Abschnitten: und Ausrichten der ersten oder mehrerer Kontaktflächen mit den zweiten Kontaktflächen, um die erste Solarzelle und die zweite Solarzelle elektrisch zu verbinden, wodurch die ersten und zweiten Solarzellen in einer schindelartigen Weise angeordnet sind, sodass ein Überlappungsbereich (114) in der Breitenrichtung über den Kontaktflächen größer als an Punkten zwischen den Kontaktflächen ist.

13. Verfahren nach Anspruch 12, wobei
die erste Solarzelle und die zweite Solarzelle jeweils eine ebene Siliciumstruktur aufweisen, wobei die ebene Siliciumstruktur eine Vorderseite und eine Rückseite aufweist, wobei die Vorderseite so konfiguriert ist, dass sie einer Lichteinfallsrichtung zugewandt ist, um Energie von einer Lichtquelle zu empfangen, wobei die erste lange Kante von der ebenen Siliciumstruktur ist,
das Verfahren ferner das Anordnen der ersten Kontaktflächen in den hervorstehenden Abschnitten auf der Vorderseite umfasst, wobei die ersten Kontaktflächen so konfiguriert sind, dass sie mit den zweiten Kontaktflächen auf der Rückseite der zweiten Solarzelle ausgerichtet sind, um die erste Solarzelle elektrisch mit der zweiten Solarzelle zu verbinden.

## Revendications

1. Dispositif solaire, comprenant :
une première cellule solaire (102) configurée pour avoir un premier bord long (102d) de forme non linéaire avec des parties saillantes et comprend des premiers plots de contact (116a-116f, 802) disposés dans les sommets respectifs des parties saillantes, le premier bord long s'étendant dans le sens de la longueur entre les extrémités respectives de deux bords courts opposés qui s'étendent dans le sens de la largeur ; et
une deuxième cellule solaire (104) conçue pour avoir un bord long (104c) chevauchant le premier bord long (102d)
au niveau des parties saillantes de la première cellule solaire (102), le bord long (104c) de la deuxième cellule solaire a une forme non linéaire avec des parties saillantes et
comprenant des deuxièmes plots de contact (116a-116f, 802) dans les sommets respectifs des parties saillantes et qui sont alignés avec les premiers plots de contact (116a-116f, 802) pour connecter électriquement la première cellule solaire (102) et la deuxième cellule solaire (104), moyennant quoi les première et
deuxième cellules solaires sont agencées de manière imbriquée de sorte qu'une zone de chevauchement (114) dans le sens de la largeur est plus grande sur les plots de contact (116a-166f, 802) qu'aux points entre les plots de contact.

2. Dispositif solaire selon la revendication 1, dans lequel le premier bord long possède une forme sinusoïdale.

3. Dispositif solaire selon la revendication 1, dans lequel la deuxième cellule solaire est conçue pour chevaucher au-dessus d'une face avant (102a) de la première cellule solaire au niveau des parties saillantes, la face avant de la première cellule solaire étant conçue pour faire face à une direction de lumière entrante.

4. Dispositif solaire selon la revendication 1, dans lequel la première cellule solaire est conçue pour avoir un second bord long de forme linéaire, le second bord long s'étendant dans les mêmes directions que le premier bord long.

5. Dispositif solaire selon la revendication 1, dans lequel la première cellule solaire est configurée pour avoir un second bord long de forme non linéaire, le second bord long s'étendant dans le même sens de la longueur que le premier bord long.

6. Dispositif solaire selon la revendication 1, dans lequel la première cellule solaire est conçue pour avoir un second bord long qui chevauche une troisième cellule solaire au niveau des parties saillantes d'un bord non linéaire de la troisième cellule solaire, et la première cellule solaire et la troisième cellule solaire sont connectées électriquement par des plots de contact alignés positionnés au niveau des parties superposées de la première cellule solaire et de la troisième cellule solaire.

7. Dispositif solaire selon la revendication 1, dans lequel chacune de la première cellule solaire et de la deuxième cellule solaire ayant une structure plane en silicium avec une face avant et une face arrière, la face avant étant conçue pour faire face à une direction de lumière entrante afin de recevoir de l'énergie d'une source de lumière ; le premier bord long est de structure plane en silicium ; et
les premiers plots de contact sont disposés dans les parties saillantes sur le côté avant, les premiers plots de contact sont configurés pour s'aligner avec les seconds plots de contact sur le côté arrière de la deuxième cellule solaire pour connecter électriquement la première cellule solaire à la deuxième cellule solaire.

8. Dispositif solaire selon la revendication 7, dans lequel le premier bord long possède une forme sinusoïdale.

9. Dispositif solaire selon la revendication 7, comprenant en outre :
un second bord long de la structure plane en silicium conçu pour avoir une forme linéaire, le second bord long s'étendant dans les mêmes directions que le premier bord long.

10. Dispositif solaire selon la revendication 7, comprenant en outre :
un second bord long de la structure plane en silicium conçu pour avoir une forme non linéaire, le second bord long s'étendant dans les mêmes directions que le premier bord long.

11. Dispositif solaire selon la revendication 7, comprenant en outre :
d'autres plots de contact disposés sur la face arrière de la première cellule solaire le long d'un second bord long de la structure plane en silicium, les autres plots de contact sont configurés pour s'aligner avec des plots de contact sur une face avant d'une troisième cellule solaire pour connecter électriquement la première cellule solaire avec la troisième cellule solaire.

12. Procédé, comprenant :
la formation d'une première cellule solaire (102) qui a un premier bord long (102d) de forme non linéaire avec des parties saillantes et comprend des premiers plots de contact (116a-116f, 802) disposés dans les sommets respectifs des parties saillantes, le premier bord long s'étendant dans le sens de la longueur entre les extrémités respectives de deux bords courts opposés qui s'étendent dans le sens de la largeur ;
la formation d'une deuxième cellule solaire (104) qui a un bord long (104c) de forme non linéaire avec
des parties saillantes et comprenant des deuxièmes plots de contact (116a-116f, 802) dans les sommets respectifs des parties saillantes ;
le chevauchement de la deuxième cellule solaire avec la première cellule solaire au niveau des parties saillantes ; et l'alignement du ou des premiers plots de contact avec les deuxièmes plots de contact pour connecter électriquement la première cellule solaire et la deuxième cellule solaire, moyennant quoi les première et deuxième cellules solaires sont disposées de manière imbriquée de sorte qu'une zone de chevauchement (114) dans le sens de la largeur est plus grande sur les plots de contact qu'aux points entre les plots de contact.

13. Procédé selon la revendication 12, dans lequel,
chacune de la première cellule solaire et de la deuxième cellule solaire ayant une structure plane en silicium, la structure plane en silicium ayant une face avant et une face arrière, la face avant étant conçue pour faire face à une direction de lumière entrante pour recevoir de l'énergie d'une source de lumière, le premier bord long a la structure plane en silicium,
le procédé comprenant en outre la disposition des premiers plots de contact dans les parties saillantes sur le côté avant, les premiers plots de contact étant configurés pour s'aligner avec les deuxièmes plots de contact sur le côté arrière de la deuxième cellule solaire pour connecter électriquement la première cellule solaire et la deuxième cellule solaire.
